# EUROPÄISCHE PATENTSCHRIFT

(11) **EP 1 083 781 B1**
(45) Veröffentlichungstag und Bekanntmachung des Hinweises auf die Patenterteilung: **23.05.2007**
(21) Anmeldenummer: 00116829.3
(22) Anmeldetag: 04.08.2000
(51) Int. Cl.: H05K 7/14, H05K 7/20, H05K 5/04

(54) **Gehäuse für elektronische Baugruppen**
Enclosure for electronic equipment
Boîtier pour équipement électronique

(30) Priorität: 08.09.1999 DE 19942826
(43) Veröffentlichungstag der Anmeldung: 14.03.2001
(73) Patentinhaber: Diehl Aerospace GmbH, 88662 Überlingen (DE)
(72) Erfinder: Kummle, Wolfgang, 88682 Salem (DE); Stolle, Dieter, 88662 Überlingen (DE); Schreiber, Alfred, 88662 Überlingen (DE)
(74) Vertreter: Diehl Patentabteilung

(56) Entgegenhaltungen:
- DE-U- 9 213 671
- DE-U- 9 308 537
- DE-U- 29 712 951
- FR-A- 2 598 585

## Beschreibung

Die Erfindung betrifft ein Gehäuse für elektronische Baugruppen mit Leiterplatten und an den Leiterplatten angebrachten Kühlblöcken.

Bei elektronischen Baugruppen oder Geräten sind in einem Gehäuse Leiterplatten montiert, auf denen elektrische und elektronische Bauteile montiert sind. Die Bauteile erzeugen im Betrieb Wärme, die abgeführt werden muß. Zu diesem Zweck ist es bekannt, auf einer Seite der Leiterplatten Kühlblöcke zu montieren.. Diese nehmen die erzeugte Wärme auf. Wegen der großen Wärmekapazität der Kühlblöcke, hält sich die Erwärmung der Kühlblöcke dabei in Grenzen. Die Kühlblöcke sind mit dem Gehäuse verbunden, so daß die von den Kühlblöcken aufgenommene Wärme zu dem Gehäuse abgeleitet wird. Das Gehäuse muß gut maßhaltig sein, so daß es seinerseits sicher in Halterungen montiert werden kann.

Durch DE 38 41 893 C2 ist ein Lastschaltmodul für Kraftfahrzeuge mit einem einseitig offenen Gehäuse zur Aufnahme einer Leiterplatte bekannt. Die Gehäuseöffnung wird durch einen mit der Leiterplatte verbundenen Gehäusedeckel verschlossen. Die Wärmeabfuhr der an der Leiterplatte vorgesehenen elektronischen Bauteile erfolgt über einen besonders ausgebildeten Kühlkörper. Der Kühlkörper enthält eine Schar von stabförmigen Trägern mit einem T-Profil. Die einzelnen Träger sind in einer an der Leiterplatte befestigten Halterung parallel nebeneinander angeordnet und bilden eine im wesentlichen geschlossene Wärmekontaktfläche, welche wärmeleitend an der Innenfläche einer metallischen Außenwand des Gehäuses anliegt.

Durch DE 92 13 671 U1 ist ein Gehäuse für eine elektronische Schaltungsanordnung bekannt, welches aus mindestens zwei Gehäuseteile besteht und zur Kühlung von elektrischen Bauteilen geeignet ist, wobei eine möglichst einfache wärmeleitende Verbindung zwischen Gehäuse und einem elektrischen Bauteil hergestellt werden soll. Dies erfolgt durch eine in einem der Gehäuseteile gehalterte Haltefeder, welche das elektrische Bauteil an die Innenwand eines anderen Gehäuseteils drückt.

Durch DE 42 42 944 A1 ist ein elektrisches Gerät mit einem mehrteiligen Gehäuse bekannt, in welchem mehrere Leiterplatten in wenigstens zwei Gehäuseteilen sowie zu kühlenden Leistungsbauelementen angeordnet sind. Die Leistungsbauelemente werden durch Haltefeder an die Innenwand bzw. an Fortsätze des Gehäuses gedrückt, wodurch die Verlustwärme abgeleitet wird.

Durch DE 197 00 558 C1 ist ein Gehäuse für elektronische Bauteile bekannt. Das Gehäuse besteht aus zwei rinnenförmigen Halbschalen. Die Halbschalen weisen Aufnahmerinnen und Leisten auf, welche paarig zueinander passen, so daß Schraubkanäle gebildet werden, in welche eine Stirnplatte eingreift, welche die Halbschalen zusammenhält. Auf diese Weise wird der Zusammenhalt des Gehäuses nach dem Zusammenschieben der Halbschalen gesichert.

Durch FR-A-2 598 585 ist ein mechanisch dichtes Gehäuse für elektronische Bauteile bekannt welches aus zwei Gehäuseteilen besteht und zur Kühlung dieser Bauteile geeignet ist.
Das Gehäuse besteht aus zwei zusammengefügten, ineinander greifenden Strangpreßprofilen.
Diese U-Profile sind übereinstimmend und in Bezug auf ihre Mittelebene unsymmetrisch ausgebildet (s. Fig. 6).
Die Innenseitenwangen weisen Rinnen auf ihre gesammte Länge auf die das Festhalten von Leiterplatten ermöglichen.
Die von den elektronischen Bauteilen erzeugte Wärme wird über das Gehäuse abgeführt.

Der Erfindung liegt die Aufgabe zu Grunde, bei solchen elektronischen Baugruppen ein maßhaltiges Gehäuse mit einfachen Mitteln aufzubauen, wobei ein guter Wärmeübergang zwischen den Kühlblöcken und dem Gehäuse gewährleistet ist.

Erfindungsgemäß wird diese Aufgabe dadurch gelöst, daß die Seitenwände des Gehäuses aus zwei Strangpreß U-Profilen mit je einem Mittelteil und rechtwinklig zu dem Mittelteil abgewinkelten Seitenwangen bestehen, die U-Profile längs der Längskanten der Seitenwangen mit Spiel ineinandergreifen und die Mittelteile der U-Profile mit gegenüberliegenden Stirnseiten der Kühlblöcke verbunden sind.

Die Abmessungen des Gehäuses werden dann durch die Abmessungen der Kühlblöcke bestimmt, Es ist stets ein guter Wärmeübergang zwischen den Kühlblöcken und dem Gehäuse gewährleistet. An die Toleranzen der U-Profile werden dabei relativ geringe Anforderungen gestellt.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.
- Fig.1: zeigt den Querschnitt eines aus zwei Strangpreßprofilen zusammengesetzten Gehäuses.
- Fig.2: ist eine Seitenansicht des Gehäuses und veranschaulicht das Zusammensetzen der beiden Gehäusehälften.
- Fig.3: ist eine Ansicht des elektronischen Gerätes von oben in Fig.2 gesehen, wobei Teile der Gehäuseoberseite weggelassen sind.
- Fig.4: ist eine Ansicht von links in Fig.3 gesehen.
- Fig.5: zeigt einen Deckel, durch welchen das Gehäuse auf einer Stirnseite abgeschlossen ist.

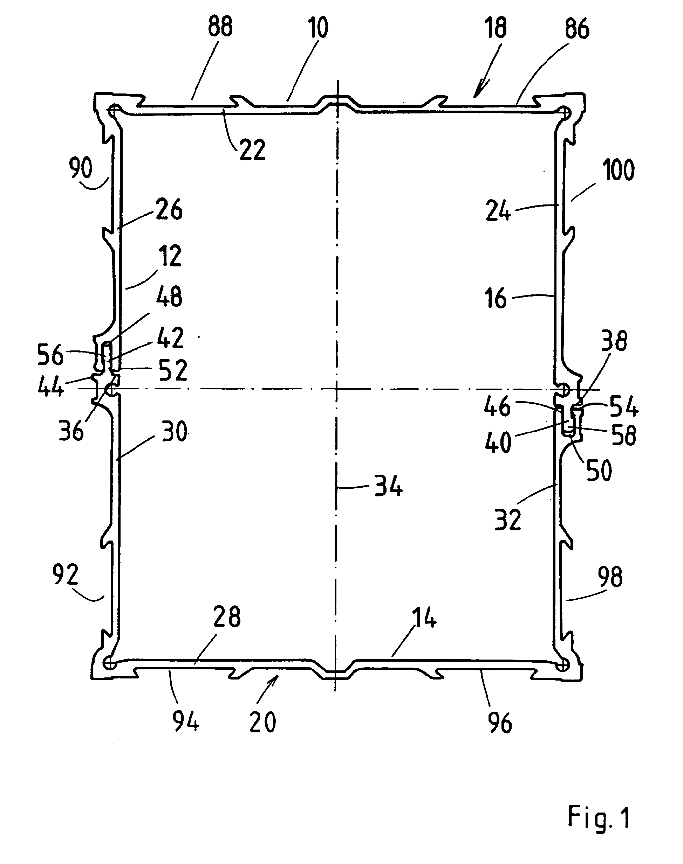

Fig.1 zeigt einen Querschnitt eines rechteckigen Gehäusemantels mit vier Seitenwänden 10, 12, 14 und 16 eines Gehäuses für elektronische Baugruppen. Die vier Seitenwände sind von zwei eckigen U-Profilen 18 und 20 gebildet. Die U-Profile sind als Strangpreßprofile hergestellt. Das U-Profil 18 hat einen Mittelteil 22, eine erste Seitenwange 24 und eine zweite Seitenwange 26. Das U-Profil 20 hat einen Mittelteil 28, eine erste Seitenwange 30 und eine zweite Seitenwange 32. Die Mittelteile 22 und 28 bilden die zwei gegenüberliegenden Seitenwände 10 und 14. Die fluchtenden Seitenwangen 26 und 30 bilden zusammen die zu den Seitenwänden 10 und 12 senkrechte Seitenwand 12. Die fluchtenden Seitenwangen 24 und 32 bilden zusammen die ebenfalls zu den Seitenwänden 10 und 12 senkrechte, der Seitenwand 12 gegenüberliegende Seitenwand 16.

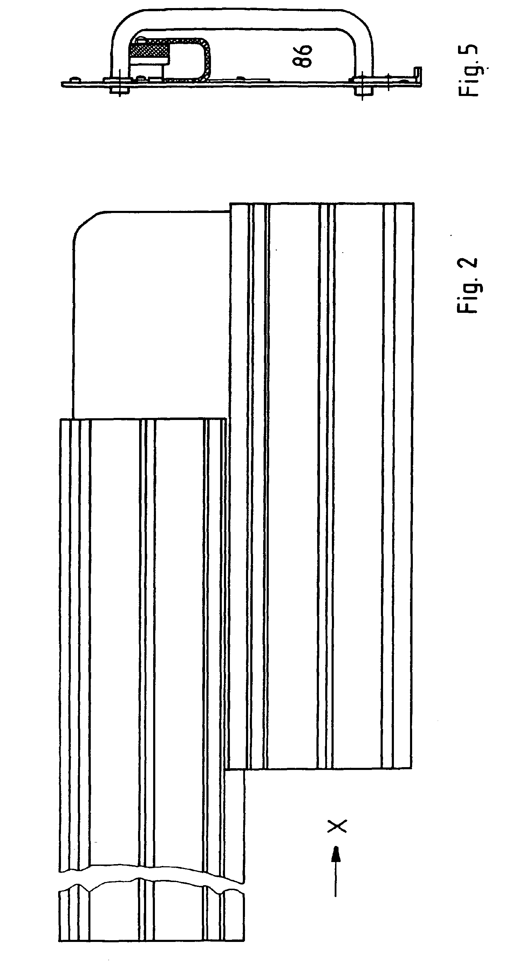

Die beiden U-Profile 18 und 20 sind übereinstimmend und in bezug auf Ihre Mittellinie 34 unsymmetrisch ausgebildet. Die freien Längskanten der 36 und 38 der ersten Seitenwangen 24 bzw. 30 weisen eine vorstehende Leiste 40 bzw. 42 auf. Die freien Längskanten 44 bzw. 46 der zweiten Seitenwangen 26 und 32 bilden Nuten 48 bzw. 50. Die Leisten 40 und 42 der Seitenwangen 24 bzw. 30 greifen in die Nuten 50 bzw. 48 der damit fluchtenden Seitenwangen 26 bzw. 32 des jeweils anderen U-Profils 20 bzw. 18 ein. Die Nuten 48 und 50 sind an ihrer Öffnung durch eine längsverlaufende Wulst 52 bzw. 54 etwas verengt. Die Leisten 42 und 40 weisen an ihren Enden je eine längsverlaufende Wulst 56 bzw. 58 auf. Die Leisten 42 und 40 können daher nur in Längsrichtung von der Stirnseite her in die Nuten 48 bzw. 50 eingeschoben werden, wie das in Fig.2 dargestellt ist.

In dem so zusammengesteckten Zustand sind die beiden U-Profile gegen Auseinanderziehen gesichert. Die Leisten 42 und 40 sind durch die Wülste 52, 56 bzw. 54, 58 in den Nuten 48 bzw. 50 gehalten.. Wie aus Fig. 1 erkennbar ist, sind die Nuten 48 und 50 etwas tiefer als die Höhe der zugehörigen Leisten 42 bzw, 40. Dadurch sind die beiden U-Profile 18 und 20 mit gewissem Spiel vertikal in Fig. 1 gehalten.

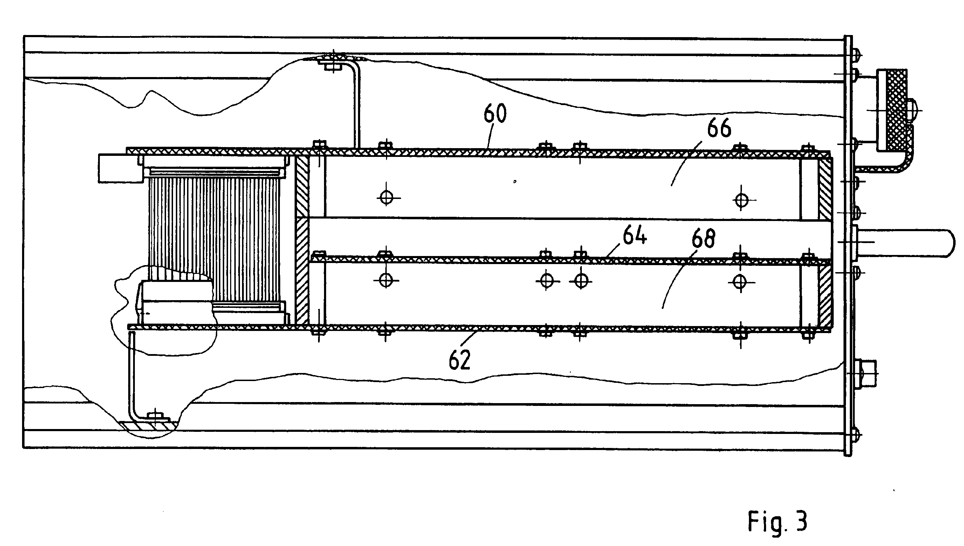

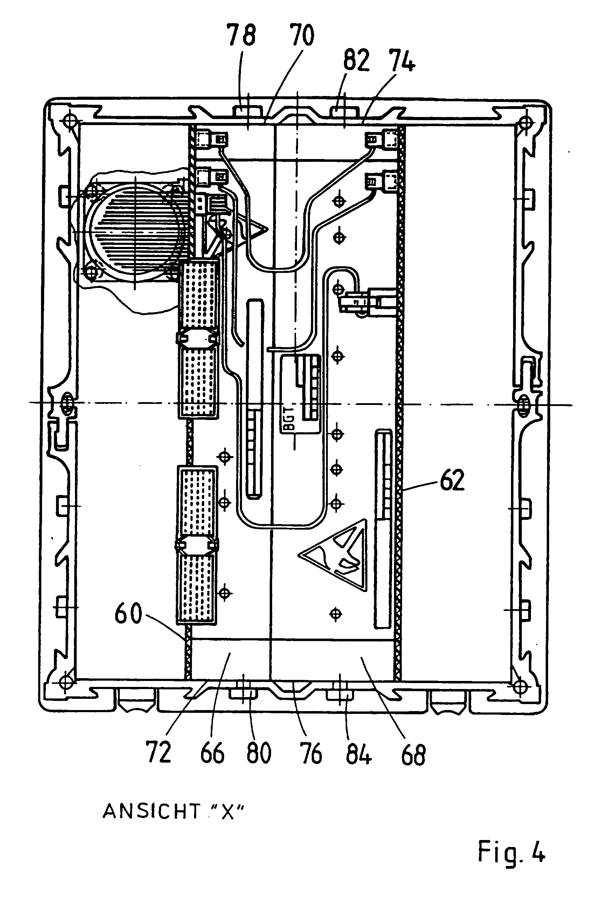

Wie aus Fig.3 und 4 ersichtlich ist, weist die elektronische Baugruppe bei dem beschriebenen Ausführungsbeispiel drei Leiterplatten 60, 62 und 64 auf. Die Leiterplatten tragen elektrische und elektronische Bauteile, deren spezielle Art und Schaltung im vorliegenden Fall für die Erfindung irrelevant und daher nicht im einzelnen beschrieben sind. Diese elektrischen und elektronischen Bauteile produzieren Wärme, die über das Gehäuse abgeführt werden muß.

Zu diesem Zweck sitzen auf den Rückseiten der Leiterplatten 60 und 62 Kühlblöcke 66 bzw. 68 montiert. Die Kühlblöcke 66 und 68 haben quaderförmige Gestalt. Die Leiterplatte 64 sitzt auf der Rückseite, abgewandt von der Leiterplatte, des Kühlblocks 68.. Wie aus Fig.3 und 4 ersichtlich ist, erstrecken sich die Leiterplatten parallel zu den Seitenwangen und zwischen den Mittelteilen 22 und 28 des Gehäusemantels. In entsprechender Weise erstrecken sich auch die Kühlblöcke 66 und 68 parallel zu den Seitenwangen zwischen den Mittelteilen 22 und 28. Die Kühlblöcke 66 und 68 sind genau bearbeitet. Die Höhe der Kühlblöcke 66 und 68 zwischen den Stirnflächen 70, 72 bzw. 74, 76 ist genau definiert.. Mit diesen Stirnflächen 70, 72 und 74, 76 sind die Kühlblöcke 66 bzw. 68 mit den Mittelteilen 22 bzw. 28 verbunden. Die Verbindung erfolgt durch Schrauben 78, 80 und 82, 84.

An den Stirnflächen wird das Gehäuse durch Deckel 86, wie in Fig.5 dargestellt, abgeschlossen. Die Deckel 86 sichern die beiden U-Profile Längsrichtung und verhindern ein Auseinanderziehen, wie es in Fig.2 dargestellt ist.

Durch die beschriebene Konstruktion werden gleichzeitig verschiedene Vorteile erreicht: Das Gehäuse ist aus preisgünstigen Strangpreßteilen hergestellt. Durch Verschrauben dieser Strangpreßteile mit den genau dimensionierten Kühlblöcken 66, 68 werden trotzdem genaue Abmessungen des Gehäuses gewährleistet. Durch das Spiel zwischen den U-Profilen 18 und 20 wird ein sicherer Kontakt ohne Luftspalt zwischen den U-Profilen und den Kühlblöcken 66, 68 gewährleistet, so daß die Wärme sicher über das Gehäuse abgeführt wird.

Die U-Profile 18 und 20 sind auf der Außenseite mit Schwalbenschwanzführungen 86, 88, 90, 92, 94, 96, 98 und 100 versehen. Mittels dieser Schwalbenschwanzführung kann das so gebildete Gehäuse beliebigen, mit den Schwalbenschwanzführungen zusammenwirkenden Strukturen gehaltert werden.

## Patentansprüche

1. Gehäuse für elektronische Baugruppen mit Leiterplatten (60,62,64) und an den Leiterplatten (60,62,64) angebrachten Kühlblöcken (66,68), **dadurch gekennzeichnet, daß** die Seitenwände (10,12,14,16) des Gehäuses aus zwei Strangpreß- U-Profilen (18,20) mit je einem Mittelteil (22,28) und rechtwinklig zu dem Mittelteil (22,28) abgewinkelten Seitenwangen (24,26;30,32) bestehen, die U-Profile (18,20) längs der Längskanten (36,44;38,46) der Seitenwangen (30,26;24,32) mit Spiel ineinandergreifen und die Mittelteile (22,28) der U-Profile (18,20) mit gegenüberliegenden Stirnseiten (70,72;74,76) der Kühlblöcke (66,68) verbunden sind.

2. Gehäuse nach Anspruch 1, **dadurch gekennzeichnet, daß** die U-Profile (18,20) übereinstimmend und in bezug auf ihre Mittelebene (34) unsymmetrisch ausgebildet sind.

3. Gehäuse nach Anspruch 1, **dadurch gekennzeichnet, daß** die U-Profile (18,20) jeweils längs einer Kante (38,44) einer ersten Seitenwange (26,32) eine Nut (48,50) und längs der Kante (44,46) der anderen, zweiten Seitenwange (24,30) eine Leiste (40,42) aufweisen, wobei die U-Profile (18,20) um 180° versetzt so zusammengesetzt sind, so daß die Leiste (40) an einer ersten Seitenwange (24) eines U-Profils (18) in die Nut (50) der damit fluchtenden zweiten Seitenwange (32) des anderen U-Profils (20) und die Leiste (42) an der ersten Seitenwange (30) des anderen U-Profils (20) in die Nut (48) der damit fluchtenden zweiten Seitenwange (26) des einen U-Profils (18) eingreift.

4. Gehäuse nach einem der Ansprüche 1 bis 3, **dadurch gekennzeichnet, daß** an den Außenseiten der U-Profile (18,20) Schwalbenschwanzführungen (86,88,90,92,94, 96,98,100) angebracht sind.

## Claims

1. Housing for electronic assemblies, having printed circuit boards (60, 62, 64) and cooling blocks (66, 68) which are fitted to the printed circuit boards (60, 62, 64), **characterized in that** the side walls (10, 12, 14, 16) of the housing comprise two extruded U-profiles (18, 20) with in each case a centre part (22, 28) and side cheeks (24, 26; 30, 32) which are at right angles to the centre part (22, 28), the U-profiles (18, 20) engage in one another with play along the longitudinal edges (36, 44; 38, 46) of the side cheeks (30, 26; 24, 32), and the centre parts (22, 28) of the U-profiles (18, 20) are connected to opposing end faces (70, 72; 74, 76) of the cooling blocks (66, 68).

2. Housing according to Claim 1, **characterized in that** the U-profiles (18, 20) are formed in a corresponding manner and asymmetrically with respect to their centre plane (34).

3. Housing according to Claim 1, **characterized in that** the U-profiles (18, 20) each have a groove (48, 50) along an edge (38, 44) of a first side cheek (26, 32) and have a bar (40, 42) along the edge (44, 46) of the other, second side cheek (24, 30), with the U-profiles (18, 20) being put together so that they are offset by 180° such that the bar (40) on a first side cheek (24) of a U-profile (18) engages in the groove (50) of the second side cheek (32), which is flush with it, of the other U-profile (20), and the bar (42) on the first side cheek (30) of the other U-profile (20) engages in the groove (48) of the second side cheek (26), which is flush with it, of the first U-profile (18).

4. Housing according to one of Claims 1 to 3, **characterized in that** dovetail guides (86, 88, 90, 92, 94, 96, 98, 100) are arranged on the outer faces of the U-profiles (18, 20).

## Revendications

1. Boîtier destiné à des modules électroniques comportant des cartes à circuit imprimé (60,62,64) et des blocs de refroidissement (66,68) appliqués contre les cartes à circuit imprimé (60,62,64), **caractérisé en ce que** les parois latérales (10,12,14,16) du boîtier sont constituées de deux profilés en U extrudés (18,20) présentant chacun une partie centrale (22,28) et des flasques latéraux (24,26 ;30,32) pliés perpendiculairement à la partie centrale (22,28), les profilés en U (18,20) sont en prise l'un avec l'autre le long des bords longitudinaux (36,44 ;38,46) des flasques latéraux (30, 26 ;24,32) en laissant un jeu et les parties centrales (22,28) des profilés en U (18,20) sont raccordées aux faces frontales opposées (70,72 ;74,76) des blocs de refroidissement (66,68).

2. Boîtier selon la revendication 1, **caractérisé en ce que** les profilés en U (18,20) sont conformés de façon à concorder et de manière asymétrique par rapport à leur plan central (34).

3. Boîtier selon la revendication 1, **caractérisé en ce que** les profilés en U (18,20) présentent chacun le long d'un bord (38,44) d'un premier flasque latéral (26,32) une rainure (48,50) et le long du bord (44, 46) de l'autre second flasque latéral (24,30) un listeau (40,42), les profilés en U (18,20) décalés de 180° étant assemblés de telle façon que le listeau (40) sur un premier flasque latéral (24) d'un profilé en U (18) soit en prise avec la rainure (50) du second flasque latéral (32) de l'autre profilé en U (20), lequel est aligné sur ladite rainure et que le listeau (42) sur le premier flasque latéral (30) de l'autre profilé en U (20) soit en prise avec la rainure (48) du second flasque latéral (26) dudit un profilé en U (18), lequel est aligné sur cette dernière rainure.

4. Boîtier selon l'une quelconque des revendications 1 à 3, **caractérisé en ce que** des guides en queue d'aronde (86,88,90,92,94,96,98,100) sont prévus sur les faces extérieures des profilés en U (18,20).
